# EUROPEAN PATENT SPECIFICATION

(11) **EP 0 425 966 B1**
(45) Date of publication and mention of the grant of the patent: **16.03.1994**
(21) Application number: 90120231.7
(22) Date of filing: 22.10.1990
(51) Int. Cl.: H05K 13/00, H01L 21/60

(54) **Method for controlling wire loop height**
Verfahren für die Überprüfung der Drahtschleifenhöhe
Procédé pour contrôler la hauteur d'une boucle de fil

(30) Priority: 02.11.1989 US 430543
(43) Date of publication of application: 08.05.1991
(73) Proprietor: MOTOROLA, INC., Schaumburg, IL 60196 (US)
(72) Inventor: Pollock, Randy, Scottsdale, Arizona 85251 (US)
(74) Representative: Ibbotson, Harold

(56) References cited:
- JP-A- 1 246 841
- JP-A- 5 984 534
- JP-A-61 244 036

## Description

### Background of the Invention

This invention relates in general to the manufacture of electronic modules and more particularly to methods for controlling the loop height for wires used to interconnect specific circuit elements contained in such modules.

During the manufacture of certain electronic modules an apparatus called a wire bonder is used to provide an electrical connection between circuit elements using a plurality of wires, e.g. as disclosed in JP-A- 1-246 841. In certain RF modules the plurality of wires is used to provide a specific amount of inductance, and the height of such wires above a given reference plane within the module must therefore be controlled to a relatively close tolerance. Ordinarily this tolerance is selected based on the variation in one or more electrical performance specifications which occurs as a result of the variation in the height of these wires above the reference plane.

During manufacture the actual height of the connecting wires is ordinarily allowed to vary within this tolerance based on the electrical specification, and adjustments to the wire bond apparatus are made only when the wire height is outside tolerance based on the electrical specifications for the module.

Depending on the sampling rate used and the particular wire bond apparatus being used, the wire loop height may in a given case not only vary significantly from a desired nominal wire loop height, but in fact exceed the tolerance based on electrical specifications for a certain number of individual modules prior to detection by measurement of a given sample.

### Summary of the Invention

It is therefore an object of the present invention to provide an improved method for controlling the wire loop height of an electronic module.

The foregoing and other objects are achieved in the present invention wherein there are provided methods for controlling wire loop height as defined in independent claims 1 and 3.

Thus, the present invention provides a method for controlling the wire loop height of an electronic module wherein the amount by which a given wire loop height is allowed to vary from a desired nominal height is based not on a given electrical specification, but on the adjustment resolution of a given wire bond apparatus, since the average actual wire loop height differs from a desired nominal value by approximately the adjustment resolution of the wire bonder.

In a preferred embodiment the steps of calculating the average actual wire loop height and comparing this average to the desired nominal value are accomplished using a computer program. The computer program may further calculate the difference between the average actual wire loop height and the desired nominal height and provide an operator with a desired magnitude and direction for an adjustment to a given wire bond apparatus.

### Brief Description of the Drawings

The above and other features and objects of the present invention and the manner of attaining them will become more apparent and the invention itself will be best understood by reference to the following description of an embodiment of the invention taken in conjunction with the accompanying drawings wherein:
Figure 1 is a side view of a typical RF electronic module illustrating the critical wire loop height associated therewith;
Figure 2 is a top view of this module showing the layout of specific circuit elements and interconnecting wires; and
Figure 3 shows a flowchart illustrating the wire loop height adjustment method of the present invention.

### Description of a Preferred Embodiment

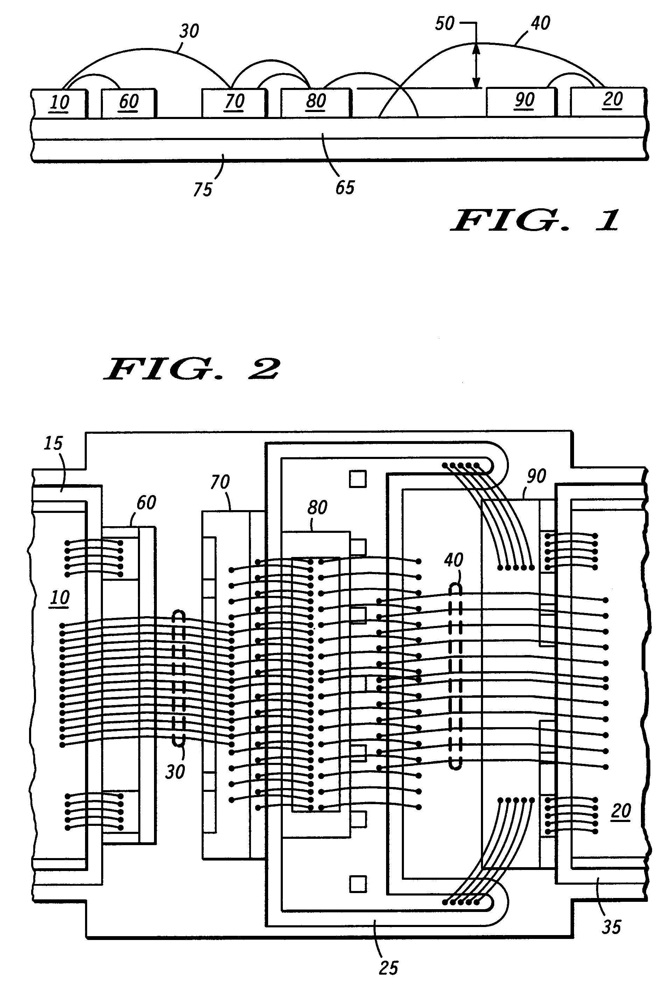

Figures 1 and 2 are respective side and top views of a typical RF module which might be constructed using a wire loop height adjustment method in accordance with the present invention. Such a module may be constructed, for example, by applying a metalized layer 65 over an insulating substrate 75 and then attaching individual circuit elements to predetermined portions of the metalized layer.

Voids 15, 25, and 35, as shown in Figure 2, are used to isolate certain portions of the metalized layer from each other. Specific circuit elements such as capacitors 60, 70, and 90 and a transistor die 80 are placed on the metalized layer in predetermined locations. Areas 10 and 20 would be, for example, respective input and output terminals for external connection of the module.

As can be seen, groups of wires are then used to interconnect the various circuit elements and portions of the metalized layer. For example, wire group 30 is used to connect input terminal 10 to capacitor 70. In a similar fashion wire group 40 is used to connect output terminal 20 to that portion of the metalized layer within isolation region 25.

It is the height of these and other wire loops, illustrated for example as dimension 50 for wire group 40 in Figure 1, which determines the inductance of the connection between the circuit elements in question. Depending on the specific electrical circuit and the operating frequency, this inductance value, and therefore the height of a given wire loop above a reference plane such as the top of transistor die 80, may be very critical and therefore must be controlled to a specific tolerance.

Ordinarily the allowable tolerance for these wire loop heights would be based upon the variation of one or more electrical characteristics of the circuit with variations in the wire loop height. While this may be satisfactory from a performance standpoint, the allowable tolerance based on the electrical characteristics may in some cases allow a significant variation of the wire loop height from a desired nominal value. Depending on the particular wire bond machine being used and other factors, certain individual modules may in fact exceed the desired tolerance before the out-of-tolerance condition is discovered by measuring the wire loop height of a specific periodic sample module.

In some cases the particular wire bond apparatus being used may have a wire height adjustment resolution which would allow for corrections to the wire height in much smaller increments than would be necessary to maintain the wire height within the tolerances required by the electrical specifications. In these cases it has been found desirable to utilized a tolerance, and make wire height adjustments to the wire bond apparatus, based not on the requirements for any given electrical specifications, but on the adjustment resolution of the wire bond apparatus itself.

By making these adjustments based on the wire bond apparatus adjustment resolution the actual average wire bond height is maintained at a value much closer to the desired nominal value thus greatly reducing the likelihood that any modules will be manufactured which exceed the larger tolerance based on the electrical specifications of the circuit in question.

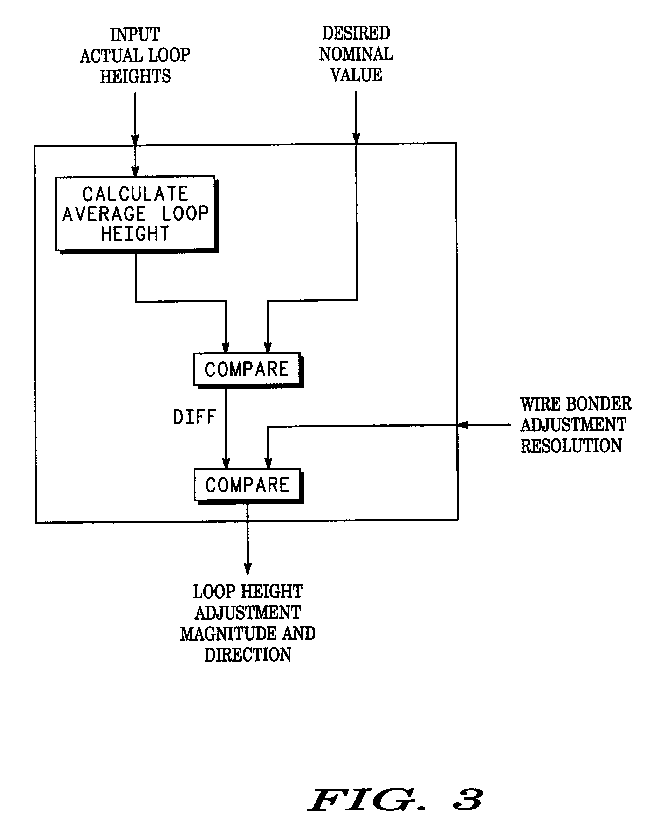

In a preferred embodiment the actual measurements of the wire heights for a given group of wires, such as group 40, are evaluated using a programmed digital computer which calculates the average of these actual measurements, compares this average actual value with the desired nominal value, compares this difference to the adjustment resolution of the wire bond apparatus and provides as an output a desired wire bond apparatus loop height adjustment magnitude and direction. The wire bond machine operator may therefore simply enter sample measurements into the computer and immediately obtain the desired adjustment, if any, to be applied to a given wire loop height. These steps are illustrated in the flowchart of Figure 3.

### EXAMPLE

In the module shown in Figures 1 and 2, metalized layer 65 is applied to a beryllium oxide insulating layer 75, and MOS capacitors 60, 70, and 90, as well as transistor die 80, are applied to appropriate areas of the metalized layer. Wires are then attached utilizing a wire bond machine such as, for example, a K&S 1470 manufactured by Kulicke and Soffa Industries of Harshima, PA. For some of the typical wire bond heights in question the allowable tolerance based on electrical parameters may be on the order of 0.0375 to 0.0500 millimeter (1 1/2 to 2 mils), while the adjustment resolution of the wire bond machine itself is on the order of 0.0125 millimeter (1/2 mil). Depending on the difference between the average actual measurement of the wire loop height of a given group of wires and the desired nominal value, the commanded wire loop height is adjusted up or down a number of motor counts wherein one motor count is the smallest amount of wire height adjustment available for the wire bond machine.

This method provides much closer control over the wire loop height of the wires used to interconnect specific circuit elements of a given electronic module and therefore reduces the probability of producing modules having interconnecting wires which exceed the wire loop height tolerances based on the electrical specifications of the module.

What has been provided therefore is a method for controlling wire loop height in connection with a wire bond apparatus wherein changes to the desired or commanded wire loop height are made based on the available adjustment resolution of the wire bond apparatus itself rather than a larger tolerance based on the desired electrical performance of the module in question.

While the above description is given in connection with a specific wire bond machine and electronic module it is to be understood that the inventive method may be used in any application where the adjustment capability of the wire bond machine is greater than the tolerance which would otherwise be required for the wire loop height based on electrical specifications of the module in question.

## Claims

1. A method for controlling wire loop height (50) during the manufacture of electronic modules comprising the steps of:
mounting at least one circuit element (60,70,80,90) on a mounting surface;
connecting said circuit element (60,70,80,90) to another such circuit element (60,70,80,90) or to a predetermined area (10,20) of said mounting surface using a wire bonder to attach a plurality of wires (30,40) therebetween which must be at a predetermined wire loop height (50) plus or minus a first predetermined amount above a reference plane in order for said electronic module to meet certain predetermined electrical specifications, wherein said wire bonder has an adjustment for changing the commanded wire loop height (50) of subsequently installed wires (30,40) by a second predetermined amount;
measuring the actual loop height (50) of each of said plurality of wires (30,40);
calculating an average actual loop height (50) for said plurality of wires (30,40);
comparing said average actual loop height (50) to said predetermined height (50); and
adjusting the commanded wire loop height (50) of said wire bonder when said average actual loop height (50) differs from said predetermined height (50) by said second predetermined amount or greater.

2. A method for controlling wire loop height (50) in accordance with claim 1 wherein said calculating and comparing steps are accomplished in a programmed digital computer.

3. A method for controlling wire loop height (50) during the manufacture of electronic modules comprising the steps of:
mounting at least one circuit element (60,70,80,90) on a mounting surface;
connecting said circuit element (60,70,80,90) to another such circuit element (60,70,80,90) or to a predetermined area (10,20) of said mounting surface using a wire bonder to attach a plurality of wires (30,40) therebetween which must be at a predetermined wire loop (50) height plus or minus a first predetermined amount above a reference plane in order for said electronic module to meet certain predetermined electrical specifications, wherein said wire bonder has an adjustment for changing the commanded wire loop height (50) of subsequently installed wires (30,40) by a second predetermined amount;
measuring the actual loop height (50) of each of said plurality of wires (30,40);
calculating an average actual loop height (50) for said plurality of wires (30,40);
comparing said average actual loop height (50) to said predetermined height (50) to obtain a difference;
comparing said difference to said second predetermined amount; and
adjusting the commanded wire loop height (50) of said wire bonder by said second predetermined amount or a multiple thereof when said average actual loop height (50) differs from said predetermined height (50) by said second predetermined amount or greater.

4. A method for controlling wire loop height (50) in accordance with claim 3 wherein said calculating and comparing steps are accomplished in a programmed digital computer.

## Patentansprüche

1. Verfahren zum Einstellen der Drahtschleifenhöhe (50) bei der Herstellung von elektronischen Baugruppen, das die folgenden Schritte umfaßt:
Montage wenigstens eines Schaltungselementes (60,70,80,90) auf einer Montagefläche;
Verbindung des Schaltungselementes (60,70,80,90) mit einem weiteren Schaltungselement (60,70,80,90) oder mit einem vorgegebenen Bereich (10,20) der Montagefläche unter Verwendung eines Drahtbonders zur Anbringung einer Vielzahl von Drähten (30,40) zwischen selbigen, die eine vorgegebene Drahtschleifenhöhe (50) plus oder minus eines ersten vorgegebenen Betrages über einer Bezugsebene haben müssen, damit die elektronische Baugruppe bestimmte vorgegebene elektrische Kennziffern erfüllt, wobei der Drahtbonder eine Einstellung zur Veränderung der angewiesenen Drahtschleifenhöhe (50) nacheinander angebrachter Drähte (30,40) um einen zweiten vorgegebenen Betrag aufweist;
Messen der Ist-Schleifenhöhe (50) jedes der Vielzahl von Drähten (30,40);
Errechnen einer durchschnittlichen Ist-Schleifenhöhe (50) für die Vielzahl von Drähten (30,40);
Vergleichen der durchschnittlichen Ist-Schleifenhöhe (50) mit der vorgegebenen Höhe (50); und Einstellen der angewiesenen Drahtschleifenhöhe (50) des Drahtbonders, wenn sich die durchschnittliche Ist-Schleifenhöhe (50) um den zweiten vorgegebenen Betrag oder mehr von der vorgegebenen Höhe (50) unterscheidet.

2. Verfahren zum Einstellen der Drahtschleifenhöhe (50) nach Anspruch 1, wobei die Schritte des Errechnens und Vergleichens in einem programmierten digitalen Computer ausgeführt werden.

3. Verfahren zum Einstellen der Drahtschleifenhöhe (50) bei der Herstellung von elektronischen Baugruppen, das die folgenden Schritte umfaßt:
Montage wenigstens eines Schaltungselementes (60,70,80,90) auf einer Montagefläche;
Verbindung des Schaltungselementes (60,70,80,90) mit einem weiteren Schaltungselement (60,70,80,90) oder mit einem vorgegebenen Bereich (10,20) der Montagefläche unter Verwendung eines Drahtbonders zur Anbringung einer Vielzahl von Drähten (30,40) zwischen selbigen, die eine vorgegebene Drahtschleifenhöhe (50) plus oder minus eines ersten vorgegebenen Betrages über einer Bezugsebene haben müssen, damit die elektronische Baugruppe bestimmte vorgegebene elektrische Kennziffern erfüllt, wobei der Drahtbonder eine Einstellung zur Veränderung der angewiesenen Drahtschleifenhöhe (50) nacheinander angebrachter Drähte (30,40) um einen zweiten vorgegebenen Betrag aufweist;
Messen der Ist-Schleifenhöhe (50) jedes der Vielzahl von Drähten (30,40);
Errechnen einer durchschnittlichen Ist-Schleifenhöhe (50) für die Vielzahl von Drähten (30,40);
Vergleichen der durchschnittlichen Ist-Schleifenhöhe (50) mit der vorgegebenen Höhe (50), um eine Differenz zu bestimmen;
Vergleichen der Differenz mit dem zweiten vorgegebenen Betrag; und
Einstellen der angewiesenen Drahtschleifenhöhe (50) des Drahtbonders um den zweiten vorgegebenen Betrag oder ein Vielfaches desselben, wenn sich die durchschnittliche Ist-Schleifenhöhe (50) um den zweiten vorgegebenen Betrag oder mehr von der vorgegebenen Höhe (50) unterscheidet.

4. Verfahren zum Einstellen der Drahtschleifenhöhe (50) nach Anspruch 3, wobei die Schritte des Errechnens und Vergleichens in einem programmierten digitalen Computer ausgeführt werden.

## Revendications

1. Procédé permettant d'ajuster la hauteur de boucle de fil (50) pendant la fabrication de modules électroniques, qui comprend les opérations suivantes :
monter au moins un élément de circuit (60, 70, 80, 90) sur une surface de montage ;
connecter ledit élément de circuit (60, 70, 80, 90) à un autre semblable élément de circuit (60, 70, 80, 90) ou à une aire prédéterminée (10, 20) de ladite surface de montage au moyen d'une soudeuse de connexions afin d'attacher entre ceux-ci une pluralité de fils (30, 40) qui doivent se trouver à une hauteur de boucle de fil prédéterminée (30) plus ou moins une première quantité prédéterminée au-dessus d'un plan de référence pour que ledit module électronique satisfasse certaines spécifications électriques prédéterminées, où ladite soudeuse de connexions possède un réglage permettant de modifier, d'une deuxième quantité prédéterminée, la hauteur de boucle de fil commandée (50) de fils ultérieurement installés ;
mesurer la hauteur de boucle réelle (50) pour chaque fil de ladite pluralité de fils (30, 40) ;
calculer la hauteur de boucle réelle moyenne (50) pour ladite pluralité de fils (30, 40) ;
comparer ladite hauteur de boucle réelle moyenne (50) avec ladite hauteur prédéterminée (50) ; et
régler la hauteur de boucle de fil commandée (50) de ladite soudeuse de connexions lorsque ladite hauteur de boucle réelle moyenne (50) présente par rapport à ladite hauteur prédéterminée (50) une différence supérieure ou égale à ladite deuxième quantité prédéterminée.

2. Procédé permettant d'ajuster la hauteur de boucle de fil (50) selon la revendication 1, où lesdites opérations de calcul et de comparaison sont effectuées dans un ordinateur numérique programmé.

3. Procédé permettant d'ajuster la hauteur de boucle de fil (50) pendant la fabrication de modules électroniques, qui comprend les opérations suivantes :
monter au moins un élément de circuit (60, 70, 80, 90) sur une surface de montage ;
connecter ledit élément de circuit (60, 70, 80, 90) à un autre semblable élément de circuit (60, 70, 80, 90) ou à une aire prédéterminée (10, 20) de ladite surface de montage au moyen d'une soudeuse de connexions afin d'attacher entre ceux-ci une pluralité de fils (30, 40) qui doivent se trouver à une hauteur de boucle de fil prédéterminée (30) plus ou moins une première quantité prédéterminée au-dessus d'un plan de référence pour que ledit module électronique satisfasse certaines spécifications électriques prédéterminées, où ladite soudeuse de connexions possède un réglage permettant de modifier, d'une deuxième quantité prédéterminée, la hauteur de boucle de fil commandée (50) de fils ultérieurement installés ;
mesurer la hauteur de boucle réelle (50) pour chaque fil de ladite pluralité de fils (30, 40) ;
calculer la hauteur de boucle réelle moyenne (50) pour ladite pluralité de fils (30, 40) ;
comparer ladite hauteur de boucle réelle moyenne (50) avec ladite hauteur prédéterminée (50) afin d'obtenir une différence ;
comparer ladite différence avec ladite deuxième quantité prédéterminée ; et
appliquer à la hauteur de boucle de fil commandée (50) de ladite soudeuse de connexions un ajustement de réglage de ladite deuxième quantité prédéterminée, ou d'un multiple de celle-ci, lorsque ladite hauteur de boucle réelle moyenne (50) présente par rapport à ladite hauteur prédéterminée (50) une différence égale ou supérieure à ladite deuxième quantité prédéterminée.

4. Procédé permettant d'ajuster la hauteur de boucle de fil (50) selon la revendication 3, où lesdites opérations de calcul et de comparaison sont effectuées dans un ordinateur numérique programmé.
